Europäisches Patentamt

European Patent Office

Office européen des brevets

(11) Publication number: **0 398 628**
**A2**

# EUROPEAN PATENT APPLICATION

(21) Application number: 90305198.5

(22) Date of filing: 15.05.90

(51) Int. Cl.5: **H01L 23/538, H01L 23/52,**
**H01L 25/065**

(30) Priority: 15.05.89 JP 118713/89
09.03.90 JP 58862/90

(43) Date of publication of application:
22.11.90 Bulletin 90/47

(84) Designated Contracting States:
DE FR GB

(71) Applicant: KABUSHIKI KAISHA TOSHIBA
72, Horikawa-Cho Saiwai-ku
Kawasaki-shi Kanagawa-ken(JP)

(72) Inventor: Yatabe, Shigeru, c/o Intellectual
Property Division, Kabushiki Kaisha Toshiba

1-1, shibaura 1-chome, Minato-ku, Tokyo(JP)
Inventor: Hongu, Akinori, c/o Intellectual
Property Division, Kabushiki Kaisha Toshiba
1-1, shibaura 1-chome, Minato-ku, Tokyo(JP)
Inventor: Yamada, Hiroshi, c/o Intellectual
Property Division, Kabushiki Kaisha Toshiba
1-1, shibaura 1-chome, Minato-ku, Tokyo(JP)
Inventor: Saito, Masayuki, c/o Intellectual
Property Division, Kabushiki Kaisha Toshiba
1-1, shibaura 1-chome, Minato-ku, Tokyo(JP)

(74) Representative: Sturt, Clifford Mark et al
MARKS & CLERK 57-60 Lincoln's Inn Fields
London WC2A 3LS(GB)

(54) Semiconductor memory device.

(57) A semiconductor memory device comprising a supporting board, a plurality of semiconductor IC chips arranged on the supporting board, in which interconnection is provided between the semiconductor chips and between the semiconductor chip and the supporting board. On the portion of the upper surface including the active area, of the semiconductor chip such as a memory IC chip bonding electrodes are arranged so as to extend substantially toward the confronting side. A plurality of such a memory IC chip are arranged on a single supporting board and the adjacent memory IC chips are directly connected by means of a bonding wire or the like. Accordingly, this semiconductor memory device allows predetermined semiconductor IC chips to be mounted more densely and more compactly without requiring arrangement of conductive patterns for connecting the semiconductor IC chips on a circuit board.

EP 0 398 628 A2

F I G. I

## Semiconductor memory device

This invention relates to a semiconductor memory device having a plurality of semiconductor integrated circuit chips directly mounted on the surface of a supporting board.

To mount semiconductor integrated circuit (IC) elements such as a memory IC element on a circuit board, a generally applied method is to package them in a DIP (Dual In-line Package) form and to solder the package on a predetermined area of the circuit board.

In response to growing demands for larger-capacity and more compact size semiconductor memory devices, a method of directly mounting "bare chip" memory IC elements on the circuit board surface has recently been employed as a new method allowing more chips to be mounted more densely, i.e., on a smaller surface area.

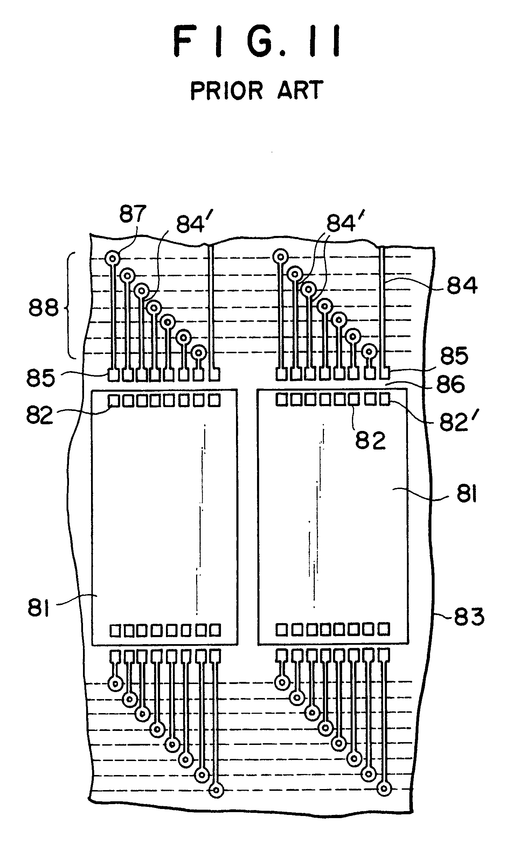

Fig. 11 is a plan view showing the structure of a memory IC device having bare chip memory IC elements directly mounted on the surface of a circuit board. As shown in this figure, the bonding pads 82 of a plurality of memory IC chips 81 are connected through bonding wires 86 to second bonding pads 85 formed at a part of interconnection patterns 84 laid out on the circuit board 83 surface. It should be noted that in the semiconductor memory device many terminals can be handled as a common signal path. In the construction shown in Fig. 11, the bonding pad 82' of the memory IC chip 81 is designated as a chip enable (CE) terminal for selecting one of the memory IC chips 81. Therefore, the interconnection patterns 84' excluding the CE terminal 82' are connected to inner bus lines 88 (indicated by dotted lines) through through-holes 87.

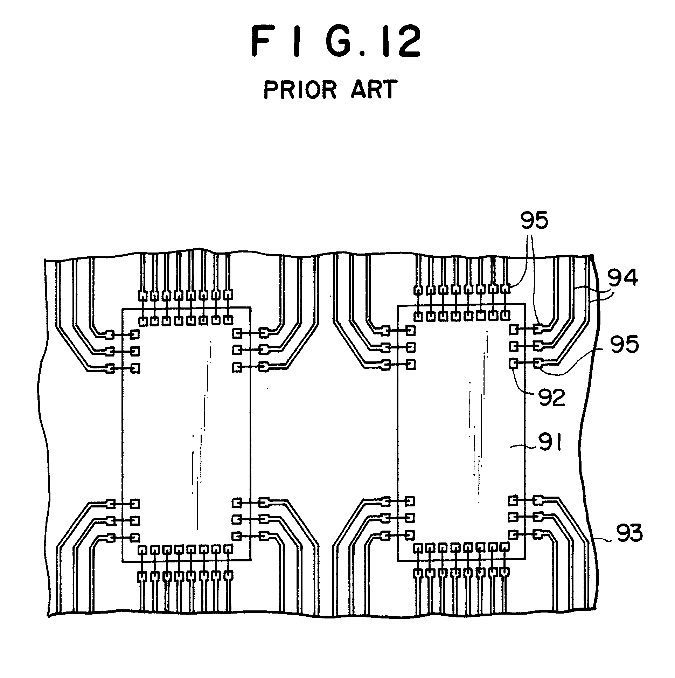

To mount the memory IC chip 81 according to the above-described wire bonding method, it is necessary to provide conductive patterns for the second bonding (second bonding pads 85 and the interconnection patterns 84 and 87) which correspond to the bonding pads 82 of the memory IC chip 81 on a part of the circuit board 83 surrounding the area in which to mount the memory IC chip 81. As shown in Fig. 12 in plane form, if the bonding pads 92 of the memory IC chip 91 are provided not on two confronting sides, but on four sides, conductive patterns for the second bonding (the second bonding pads 95 and the interconnection patterns 94) which correspond to the bonding pads 92 of the memory IC chip 91 must be arranged on all parts of the circuit board 93 serving as a supporting board surrounding the area in which to mount the memory IC chip 91.

In either of the constructions shown in Figs. 11 and 12, the area required for mounting the memory IC chip 81 or 91 is the area occupied by she memory IC chip 81 or 91 itself plus the area to be occupied by the conductive patterns for the second bonding. That is, as the number of memory IC chips 81 or 91 increases, the area to be occupied by the conductive patterns for the second bonding (second bonding pads 85, 95 and the interconnection patterns 84, 94) should become larger.

As described above, the mounting density of a circuit board can be improved to some degree by the bare chip semiconductor IC elements directly mounting on a predetermined surface of the circuit board; however, it is not sufficient to achieve a satisfactory high mounting density or the production of a larger-capacity memory. This still requires a larger mounting area as a whole, thereby hampering the improvement in mounting density and the production of smaller semiconductor memory devices.

Therefore, an object of the present invention is to provide a semiconductor memory device capable of mounting semiconductor IC chips such as memory IC chips significantly densely by achieving a substantial reduction in the mounting area.

The semiconductor memory device according to the present invention comprises: a supporting board, a plurality of semiconductor IC chips arranged on the supporting board, and interconnections for connecting between the semiconductor IC chips and between the semiconductor IC chip and the supporting board. Each of the semiconductor IC chips has at least two electrode pads receiving information from signal lines or sending information to signal lines of a single source of the semiconductor IC chip, and an interconnection means for directly interconnecting the electrode pads corresponding and adjacent to each other on each of the adjacent semiconductor IC chips.

Further, the semiconductor memory device according to the present invention is provided with bonding electrodes for the semiconductor IC chip on a portion of the active area of the upper surface (active element forming surface) of the semiconductor IC chip, e.g., a memory IC chip.

Still further, the semiconductor memory device according to the present invention is provided with bonding electrodes in parallel so as to extend substantially toward the confronting side on a portion of the upper surface including the active area of the semiconductor IC chip. In such a construction, at least one of the bonding electrodes intersects another bonding electrode, and the bonding electrodes adjacent to each other on each of the adjacent semiconductor IC chips are directly connected by interconnecting means, such as a wire bonding.

According to the present invention, a plurality of mounted semiconductor IC chips are interconnected by interconnection means such as a wire bonding that connects between the bonding electrodes on the upper surface of each of the adjacent semiconductor IC chips. - That is, it is not necessary to provide conductive patterns to connect the semiconductor IC chips on the circuit board, thereby successfully reducing the distance between the adjacent semiconductor IC chips to be mounted. Therefore, a semiconductor memory device having its IC chips mounted more densely and more compactly can be achieved.

According to the present invention, the semiconductor memory device is so constructed that the semiconductor IC chips, e.g., memory IC chips, form a pair of bonding electrodes (the conductive patterns for bonding) that are arranged so as to extend toward the confronting side on a portion of the upper surface including the active area of the memory IC chip, and are connected by wire bonding between the bonding electrodes of the adjacent chips. That is, it is no longer necessary to provide the conductive patterns for the second bonding pads that connect between the adjacent memory IC chips or the conductive patterns for interconnection between the memory IC chips on the circuit board. Therefore, the area required for the conductive patterns around each of the memory IC chips can be reduced significantly, thereby allowing a high density semiconductor memory device to be achieved. In other words, a semiconductor memory device that is smaller in size and lighter in weight can be provided.

Fig. 1 is a plan view showing an embodiment of the construction of a semiconductor memory device according to the present invention;

Fig. 2 is a sectional view taken along the line A-A' of Fig. 1;

Figs. 3 (a), (b), and (c) are diagrams schematically illustrating an example of the method of fabricating a memory IC chip used in constructing the semiconductor memory device according to the present invention;

Figs. 4 (a) and (b) show another embodiment of the construction of a semiconductor memory device according to the present invention, of which Fig. 4 (a) is a perspective view of a memory IC chip mounted and Fig. 4 (b) is a perspective view of a semiconductor memory device;

Fig. 5 is an equivalent circuit diagram of the semiconductor memory device shown in Fig. 4 (b);

Fig. 6 is a plan view showing interconnection patterns of the memory IC chip shown in Fig. 4 (a);

Figs. 7 (a) and (b) are diagrams showing still another embodiment of the construction of a semiconductor memory device according to the present invention, of which Fig. 7 (a) is a plan view of a semiconductor memory device and Fig. 7 (b) is an equivalent circuit diagram of the semiconductor memory device shown in Fig. 7 (a);

Fig. 8 is a perspective view showing still another embodiment of the construction of a semiconductor memory device according to the present invention;

Figs. 9 (a), (b), (c), and (d) are diagrams schematically illustrating still another example of the method of fabricating a memory IC chip used to construct a semiconductor memory device according to the present invention;

Fig. 10 is a sectional view showing the memory IC chip fabricated in the method shown in Fig. 9; and

Figs. 11 and 12 are plan views showing the construction of the main portions of conventional memory devices, respectively.

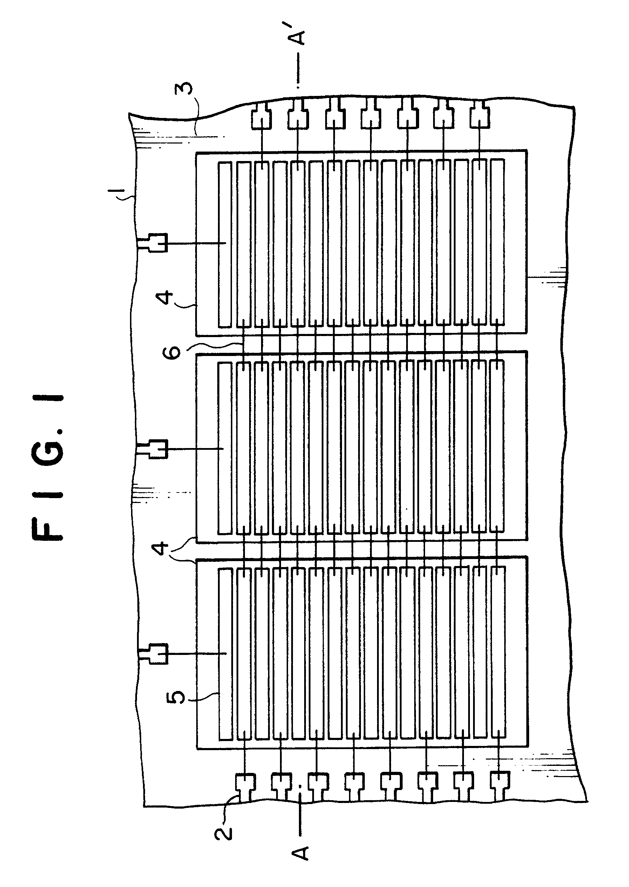

Embodiments of the present invention will now be described with reference to Figs. 1 through 10.

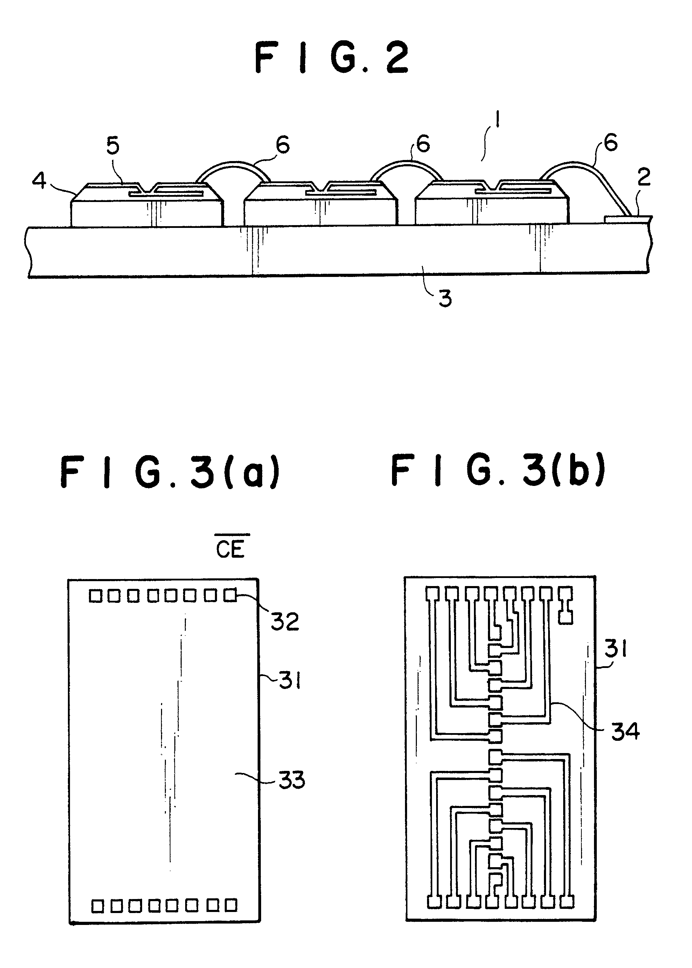

Fig. 1 is a plan view of the construction of a semiconductor memory device 1 that is an embodiment of the present invention. This semiconductor memory device 1 includes a circuit board 3 that is provided with second bonding pads 2 and a plurality of memory IC chips 4 on its surface. On the surface of each memory IC chip 4 are conductive patterns 5 arranged. The connection is made by bonding wires 6 between each conductive pattern 5 on the memory IC chip 4 and the second bonding pad 2 on the circuit board 3 and between the conductive patterns 5 on each of the adjacent memory IC chips 4. Fig. 2 is a sectional view of the embodiment shown in Fig. 1 taken along the line A-A'.

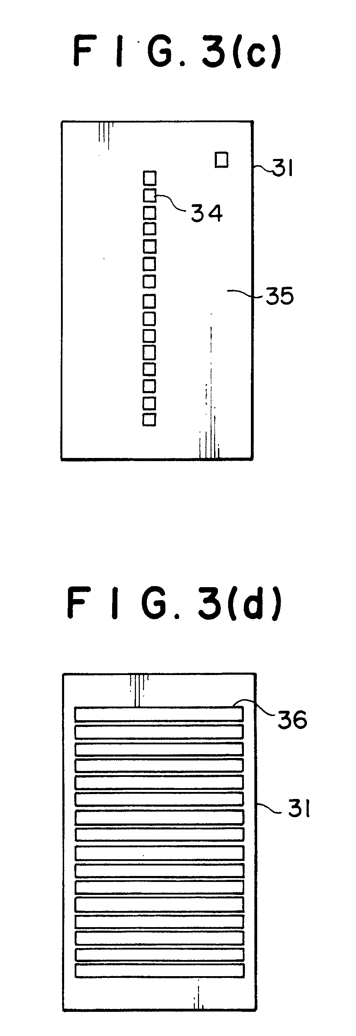

Figs. 3 (a) through 3 (d) show a method of fabricating a memory IC chip 31 to be used in constructing the semiconductor memory device according to the present invention.

Fig. 3 (a) is an example of the memory IC chip 31 used. An insulating layer is arranged, if necessary, on a passivation film 33 excluding the area for bonding pads 32. Then, a conductive film layer is arranged over the entire surface of the memory IC chip 31 and subsequently processed into interconnection patterns 34 that electrically interconnect the bonding pads 32, respectively (Fig. 3 (b)). Then, an insulating layer 35 is arranged excluding a part of the interconnection patterns 34 (Fig. 3 (c)). Thereafter, conductive patterns arranged so as to extend as far to the confronting side on the portion including the active area (the upper surface) 36 that are electrically connected to the exposed portion of the interconnection patterns 34 are provided on the insulating layer 35 (Fig. 3 (d)).

The interconnection patterns 34 and the conductive patterns 36 are prepared as follows. The conductive film is arranged over the entire surface of the memory IC chip 31 by a thin film deposition technology such as a vacuum evaporation method and a sputtering method, and is then patterned as predetermined by a photolithographic and etching process. The insulating layer 35 is arranged by forming an organic thin film made of, e.g., a polyimide resin and is patterned as predetermined by a photolithographic and etching process.

Further, it is desirable that each process (Figs. 3 (a) through (d)) should be effected when the memory IC chip is in the state of wafer. Then, the wafer thus processed is subjected to a dicing process to obtain the chips.

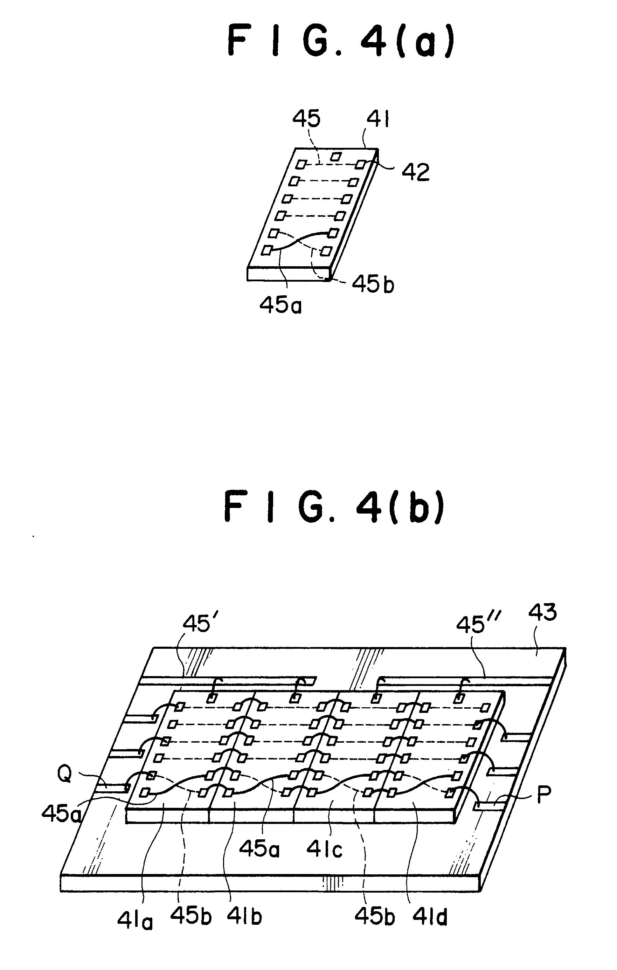

Another embodiment of the present invention will be described with reference to Figs. 4 through 6.

Fig. 4 (a) is a perspective view showing the construction of one of a plurality of memory IC chips 41 to be mounted. The basic construction of the memory IC chip used in this embodiment is similar to that in the previous embodiment. That is, the bonding pads are arranged so as to extend toward the confronting side on the portion including the active area. However, it is modified so that one of conductive patterns 45 for bonding intersects its adjacent pattern through an insulating layer; e.g., a conductive pattern 45a intersects a conductive pattern 45b through the insulating layer.

The plurality of memory IC chips 41 thus constructed are mounted on a circuit board 43 in the manner similar to the previous embodiment to constitute a semiconductor memory device whose perspective view is as shown in Fig. 4 (b).

In this semiconductor memory device a chip enable line (memory IC chip select line) 45′ is connected to the memory IC chips 41a and 41b; while an other chip enable line (memory IC chip select line) 45″ is connected to the memory IC chips 41c and 41d. If 45a is a data signal line and 45b is a bypass, data (45a of 41a), bypass (45b of 41a), data (45a of 41c) and bypass (45b of 41a) are connected and bypass (45b of 41a), data (45a of 41b), bypass (45b of 41c) and data (45a of 41d) are connected.

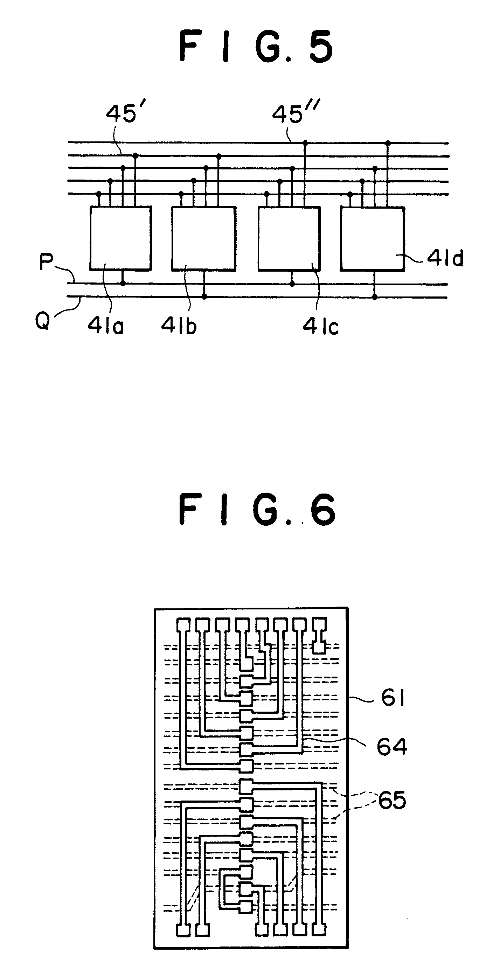

Fig. 5 is a diagram showing an equivalent circuit of the memory IC device of this construction; and Fig. 6 is a plan view showing the layout of circuit patterns 64 (equivalent of that of Fig. 3 (b)) and conductive patterns 66 of the memory IC chip used in constructing the above memory IC device.

Therefore, in case of the construction shown in Fig. 4 (b), to operate the chip enable line 45′, a conductive pattern P serves as a data signal line for the memory IC chip 41a and a conductive pattern Q for the memory IC chip 41b. On the other hand, to operate the chip enable line 45″, the conductive pattern P serves as a data signal line for the memory IC chip 41c and the conductive pattern Q for the memory IC chip 41d. This means that the memory IC chip 41 (41a, 41b, 41c, and 41d), each having eight (8) data lines and a capacity of 1 M bit being supposedly mounted, would serve to perform the same function as a memory IC chip of sixteen (16) data lines and 2 M bit by combining the memory IC chips 41a and 41b, or by combining the memory IC chips 41c and 41d.

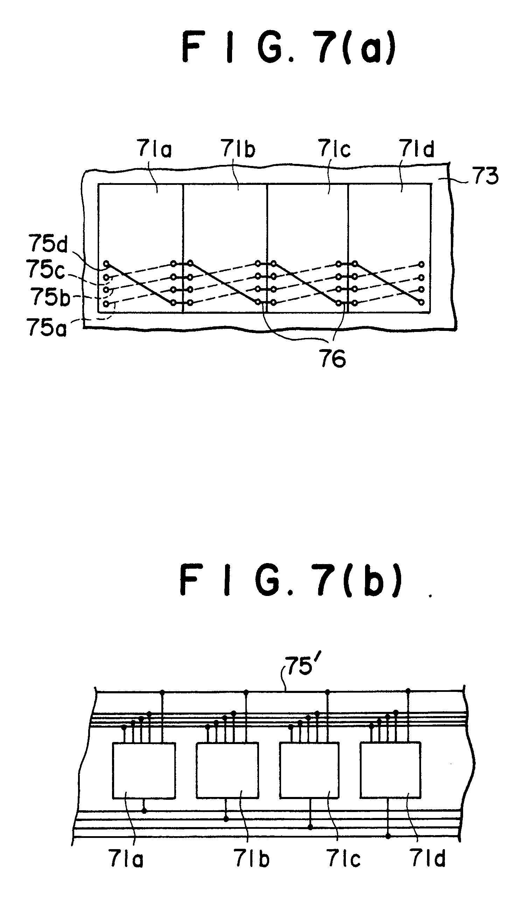

Further, Figs. 7 (a) and (b) show still another embodiment. A memory IC chip 71 used in this embodiment has the construction basically similar to that of the memory IC chip shown in Fig. 4 used in the previous embodiment. That is, the conductive patterns 75 for bonding are arranged os as to extend toward the confronting side on the part including the active area. However, it is modified so that one of conductive patterns 75 for bonding intersects another conductive pattern jumping over its adjacent conductive patterns through an insulating layer; e.g., a conductive pattern 75d intersects a conductive pattern 75c, 75b and 75a through the insulating layer.

In this way, a plurality of memory IC chips 71 of the above construction are mounted on a circuit board 73 in the manner similar to that in the previous embodiment thereby to constitute a semiconductor memory device whose plan view is as shown in Fig. 7 (a).

In this semiconductor memory device, a chip enable line 75′ is connected to the memory IC chips 71a, 71b, 71c, and 71d. Further, the conductive pattern 75d is connected to the data signal line of the memory IC chip 71a bypasses other memory IC chips 71b, 71c, and 71d. The conductive pattern 75c is connected to the data signal line of the memory IC chip 71b bypassing other memory IC chips 71a, 71c, and 71d. In this way, the memory semiconductor memory device constitutes an equivalent circuit shown in Fig. 7 (b).

Considering the fact that a memory IC chip generally has 1, 4, or 8 data lines and that a computer system usually has 8, 16, and 32 lines of data bus, it is very useful to enable e.g., a memory IC device of 16 bit data using a memory IC chip of 4 bit data by employing the construction shown in Figs. 7(a) and (b).

Although an example of using a circuit board as a supporting board and a wire bonding as a means for directly interconnecting the electrode pads adjacent to each other on each of the adjacent memory IC chips that are arranged and mounted is shown in the above embodiment, an application of a TAB (Tape Automated Bonding) method may also be applicable. That is, a tape with predetermined lead patterns, each of which has two bumps on its surface is prepared. Then, the first bump may be connected to one end of each of conductive patterns for bonding arranged on a memory IC chip, and the second bump may be connected to one end of each of conductive patterns for bonding arranged on another memory IC chip adjacent to the memory IC˙chip. In this construction, not only the supporting body and lead pattern portion excluding the area between the two bumps, which is related to the interconnection between the two adjacent memory IC chips, are cut. A burn-in test can be conducted after the first bump is connected to one end of the conductive patterns on the memory IC chip, which is an additional advantage.

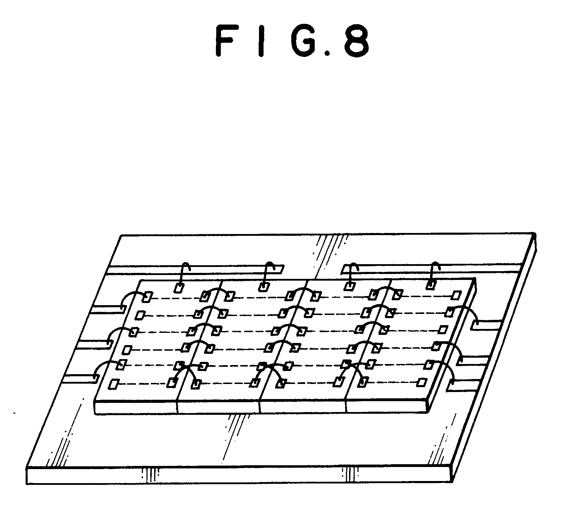

To make the memory IC device shown in Fig. 5, what is modified in the embodiment shown in Fig. 8 is that it is not the conductive patterns for bonding that are intersected as is the case with the memory IC chip shown in Fig. 4 (a), but it is the bonding wires for connecting the conductive patterns that are intersected. The bonding wires to be preferably used in this embodiment include a wire having an insulating coating of, e.g., a synthetic polymer so that the intersecting wires will not be shorted. The TAB method may replace the bonding wire method. In this case, it is required that an insulating tape having the leads arranged on both faces be intersected.

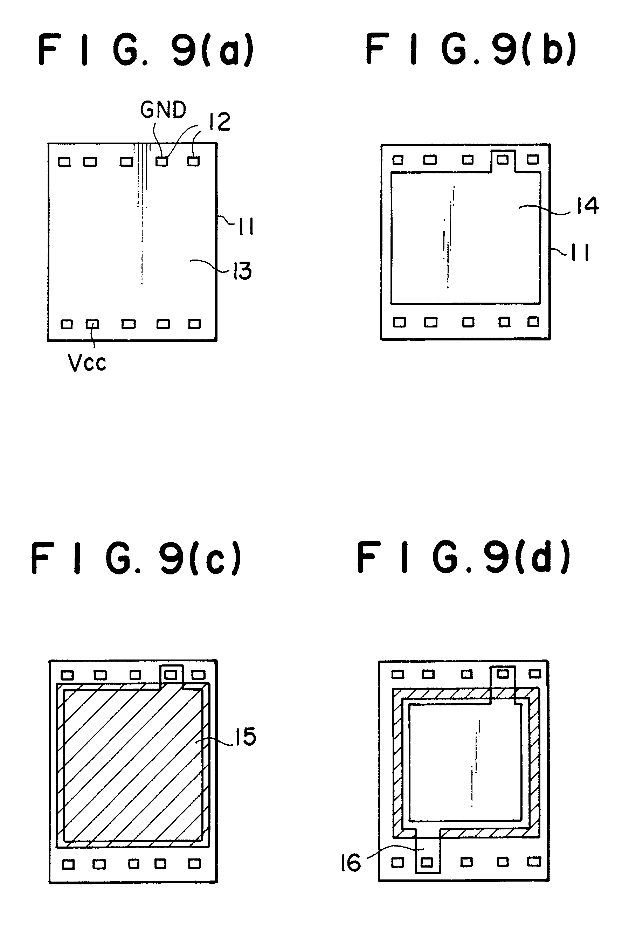

Figs. 9 (a), (b), (c), and (d) show still another embodiment, in which a bypass capacitor is provided on a semiconductor IC chip according to the present invention to achieve a still denser mounting. An insulating layer of e.g., polyimide is formed on a passivation film 13 arranged on the upper surface of a predetermined semiconductor IC chip, e.g., a memory IC chip 11 of the construction shown in Fig. 9 (a), excluding the area for the bonding pads 12.

Then, conductive films of e.g., each made of Ti, Ni, Au, and Cr, are deposited over the entire surface of the memory IC chip 11 in the order written. The layer consisting of these conductive films is etched, and as shown in Fig. 9 (b), a first conductive pattern 14 is formed. This pattern 14 has a certain surface area and is connected only to a pad among the bonding pads, e.g., a ground electrode pad GND.

Further, a dielectric layer 15 composed of e.g., barium titanate is deposited on the first conductive patterns 14 through a metal mask by means of a sputtering method or like into a desired shape as shown in Fig. 9 (c).

Then, conductive films, each being made of, e.g., Cr and Au, are deposited over the entire surface of the memory IC chip 11 in the order written. The layer of these conductive films is etched, and then a second conductive pattern 16 is formed on the area overlapping the first conductive pattern 14. This second conductive pattern 16 has a certain surface area and is connected only to among the bonding pads the power supply electrodes.

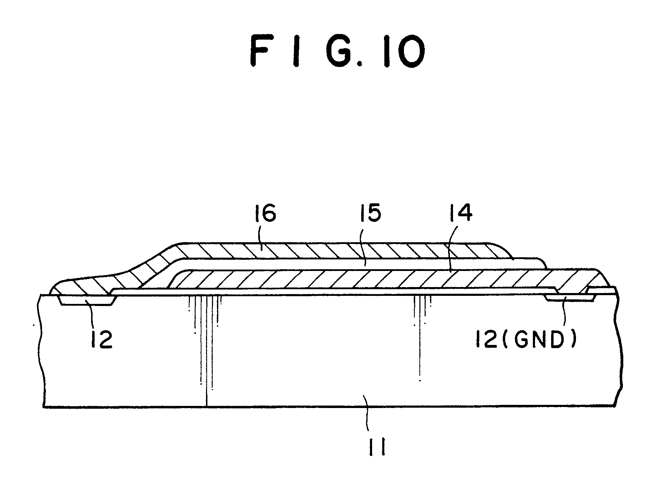

Because the insulating layer, the first conductive pattern 14, the dielectric layer 15, the second conductive pattern 16 are sequentially arranged in this way, this embodiment, the section of which being as shown in Fig. 10, can serve as a capacitor. For example, in the case where the dielectric layer 15 is formed so that its thickness is 1000 angstrom and the surface area in which the first and second electrodes overlap is 5 x 5 mm, a capacitor of about 2 $\mu$F can be obtained with the relative permittivity of barium titanate being about 1000. This capacitor has a large capacitance enough to serve as a so-called bypass capacitor for stabilizing the power supply of the memory IC chip.

Such a capacitor on a chip may be formed by dividing the area on the chip into a plurality of areas. Interconnection can be provided on the chip concurrently.

The capacitor and interconnections may be arranged in a multilayer form.

The above embodiment requires no area outside that of the semiconductor IC chip for mounting the capacitor, thereby allowing high density mounting.

Further, the interconnection length between the capacitor and the semiconductor IC is so short that the advantage provided by the capacitor as a bypass capacitor is appreciable.

Furthermore, although in the above embodiment a memory IC device is exemplified as a semiconductor memory device, the present invention may likewise be applicable to the construction of an array processor and other semiconductor device.

## Claims

1. A semiconductor memory device comprising: a supporting board;
a plurality of semiconductor IC chips arranged on said supporting board;
interconnection provided between said semiconductor IC chips and between said semiconductor IC chip and said supporting board;
said semiconductor IC chip having at least two electrode pads for receiving information from a single signal line or sending information to a single signal line and means for directly interconnecting between said electrode pads corresponding with and adjacent to each other on each of said semiconductor IC chips that are adjacent to each other.

2. A semiconductor memory device as claimed in claim 1, wherein bonding electrodes for said semiconductor IC chip is provided on a portion of the upper surface of said semiconductor IC chip including the active area.

3. A semiconductor memory device as claimed in claim 2, wherein said semiconductor IC chip with said bonding electrodes arranged comprises a passivation film formed on a portion of the upper surface of said semiconductor IC chip excluding bonding pads, a first insulating layer formed on said passivation film, interconnection patterns formed on said insulating layer and connected to said bonding pads, a second insulating layer formed on said interconnection patterns excluding a portion of said interconnection patterns, and conductive patterns farmed on said second insulating layer and electrically connected to said interconnection patterns.

4. A semiconductor memory device as claimed in claim 3, wherein said conductive patterns are arranged so that respective patterns extend in parallel toward the confronting side of said semiconductor IC chip.

5. A semiconductor memory device comprising:
a supporting board;
a plurality of semiconductor IC chips arranged on said supporting board;
interconnection provided between said semiconductor IC chips and between said semiconductor IC chip and said supporting board;
bonding electrodes being provided in parallel so as to extend substantially toward the corresponding side on a part of the upper surface including the active area of said semiconductor IC chip;
at least one of said bonding electrodes intersecting another bonding electrode;
means for directly interconnecting between said bonding electrodes adjacent to each other on each of said semiconductor IC chips that are adjacent to each other being provided.

6. A semiconductor memory device comprising: a supporting board;
a plurality of semiconductor IC chips arranged on said supporting board;
interconnection provided between said semiconductor IC chips and between said semiconductor IC chip and said supporting board;
bonding electrodes being provided in parallel so as to extend substantially toward the corresponding side on a part of the upper surface of said semiconductor IC chip excluding the active area;
means for directly interconnecting between said bonding electrodes adjacent to each other on each of said semiconductor IC chips that are adjacent to each other being provided;
at least one of said direct interconnection means for interconnecting said bonding electrodes intersecting other direct interconnection means.

7. A semiconductor memory device as claimed in claim 6, wherein said means for interconnecting said bonding electrodes is insulated.

8. A semiconductor memory device as claimed in claim 1, 2, 3, 4, 5, 6 or 7, wherein said means for interconnecting said bonding electrodes is wired by wire bonding.

9. A semiconductor memory device as claimed in claim 1, 2, 3, 4, 5, 6 or 7, wherein said means for interconnecting said bonding electrodes is wired by tape automated bonding.

10. A semiconductor memory device comprising:
a supporting board;
a plurality of semiconductor IC chips arranged on said supporting board;
interconnection provided between said semiconductor IC chips and between said semiconductor IC chip and said supporting board; and
at least one capacitor formed on the upper face of said semiconductor IC chip.

11. A semiconductor memory device comprising:
a supporting board;
a plurality of semiconductor IC chips arranged on said supporting board;
said semiconductor IC chip having at least two electrode pads for receiving information from a single signal line or sending information to a single signal line;
said electrode pads adjacent to each other on each of said semiconductor IC chips that are adjacent to each other being directly wired; and
at least one capacitor formed on the upper face of said semiconductor IC chip.

12. A semiconductor memory device as claimed in claim 10 or 11, wherein said capacitor comprises:
an insulating layer arranged on the active area of the upper surface of said semiconductor IC chip;
a first conductive pattern formed on said insulating layer and connected to at least an electrode pad;
a dielectric layer formed on said first conductive pattern; and
a second conductive pattern formed on said dielectric layer, sharing an area that overlap that of the first conductive pattern and connected to other electrodes.

13. A semiconductor memory device as claimed in claim 12, wherein said dielectric layer is essentially consisted of barium titanate.

# F I G. I

EP 0 398 628 A2

# F I G. 2

# F I G. 3(a)

$\overline{CE}$

# F I G. 3(b)

# F I G. 3(c)

# F I G. 3(d)

# F I G. 4(a)

# F I G. 4(b)

EP 0 398 628 A2

# F I G. 5

45′        45″

P

Q   4la   4lb        4lc        4ld

# F I G. 6

61

64

65

# F I G. 7(a)

71a    71b    71c    71d

73

75d
75c
75b
75a

76

# F I G. 7(b)

75'

71a    71b    71c    71d

# F I G. 8

EP 0 398 628 A2

# F I G. 9(a)

GND  I2

Vcc

II
I3

# F I G. 9(b)

I4
II

# F I G. 9(c)

I5

# F I G. 9(d)

I6

# F I G. 10

16    15    14

12                                    12(GND)

11

# FIG. 11

## PRIOR ART

# F I G. 12

## PRIOR ART